Europäisches Patentamt

European Patent Office

Office européen des brevets

(11) Publication number: **0 506 099 A2**

# EUROPEAN PATENT APPLICATION

(21) Application number: **92105331.0**

(22) Date of filing: **27.03.92**

(51) Int. Cl.⁵: **H01P 5/16, H03H 7/21**

(30) Priority: **29.03.91 JP 65967/91**

(43) Date of publication of application:
**30.09.92 Bulletin 92/40**

(84) Designated Contracting States:
**GB IT**

(71) Applicant: **HITACHI, LTD.**
**6, Kanda Surugadai 4-chome**
**Chiyoda-ku, Tokyo 101(JP)**
Applicant: **Hitachi Video & Information**
**System, Inc.**
**292, Yoshidacho Totsuka-ku**
**Yokohama-shi Kanagawa-ken 244(JP)**
Applicant: **HITACHI FERRITE LTD.**
**25-1, Haykunincho 1-chome, Shinjyuku-ku**
**Tokyo(JP)**

(72) Inventor: **Suzuki, Kazutoshi**
**Katsutaryo 205, 2-30, Taiseicho**
**Katsuta-shi(JP)**

Inventor: **Hikita, Mitsutaka**
**30-7, Yokokawamachi**
**Hachioji-shi(JP)**
Inventor: **Ishida, Yoshikatsu**
**56-15, Minamidai, Tokaimura**
**Naka-gun, Ibaraki-ken(JP)**
Inventor: **Akagi, Takatoshi**
**26-1, Fujimoto 1-chome**
**Kokubunji-shi(JP)**
Inventor: **Tanaka, Satoru**
**c/o Hitachi Ferrite Yuwaryo 207, 150-90,**
**Daikakuji**
**Tottori-shi(JP)**

(74) Representative: **Altenburg, Udo, Dipl.-Phys. et**
**al**
**Patent- und Rechtsanwälte**
**Bardehle-Pagenberg-Dost-Altenburg**
**Frohwitter-Geissler & Partner Postfach 86 06**
**20**
**W-8000 München 86(DE)**

(54) **Signal distributor.**

(57) This invention relates to a signal distributor formed in a small size without using microstrip lines. A twisted wire of insulated wires (6, 6A) is separated to the insulated wires (6, 6A), which are respectively wound at least one turn around the toroidal core (5) from mutually opposite directions, the ends (6-1, 6A-1) of the insulated wires are connected to the input terminal (1), while the insulated wire end (6-2) is connected to the output terminal (4), and the insulated wire end (6A-2) is connected to the output terminal 3. The three insulated wires (7, 7A, 7B) are twisted and wound at least one turn around the toroidal core (5), a group of the insulated wire ends (7-1, 7A-2, 7B-1) and a group of the insulated wire ends (7-2, 7A-1, 7B-2) are twisted once at outside of the toroidal core (5), the insulated wire end (7-1) is connected to the output terminal (3), the insulated wire end (7B-1) to the input terminal (2), the insulated wire end (7A-1) to the output terminal (4), and the insulated wire ends (7A-2, 7-2, 7B-2) to the earth conductor. By the above arrangement, when a signal is inputted to one of the input terminals (1, 2), signals of equiphase components are outputted at the output terminals (3, 4) and when a signal is inputted to the other of the input terminals (1, 2), signals of antiphase components are outputted at the output terminals (3, 4). Thus, a signal distributor can be formed without using microstrip lines and consequently in a reduced size.

# F I G. 2

## BACKGROUND OF THE INVENTION

This invention relates to a signal distributor provided in a radio section of a radio terminal equipment, and more particularly to a miniaturization of the circuit of the radio section.

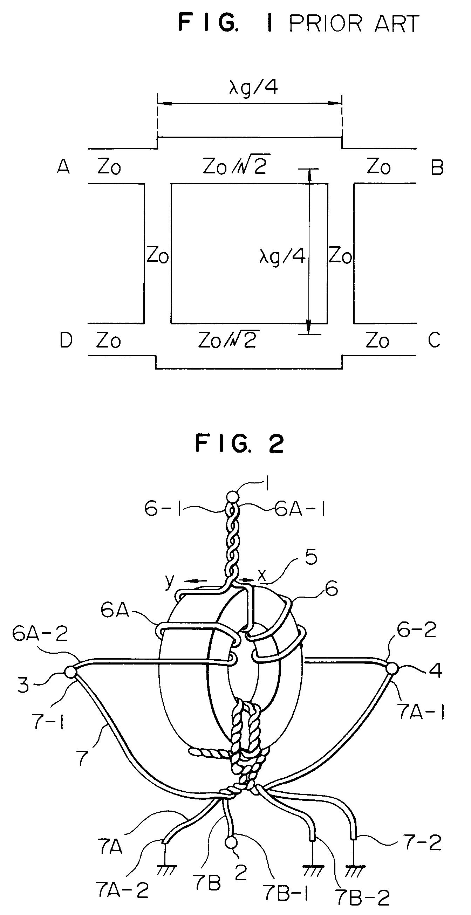

The signal distributor used in conventional radio terminal equipment is a branch line type hybrid ring shown in Fig. 1, which is formed by microstrip lines. This signal distributor is so designed as to prevent output of each signal generator from entering the other signal generator when synthesizing outputs of two signal generators. In Fig. 1, the hybrid ring utilizes the behavior of λg/4 of the microstrip line, and therefore, its isolation characteristic is low for the frequencies other than those which are λg/4 on the board. A signal input from an input terminal A or D has its energy divided and sent to output terminals B and C, and the output signals are at a level 3dB lower than the level of the input signal. Therefore, the input signals do not pass between the input terminals A and D, nor do the output signals pass between the output terminals B and C. The phase difference between the signals supplied to the output terminals B and C is 90°.

With the advancing size and weight reductions of communication devices, it has become important to reduce the size and weight of the radio section of automobile telephones. However, with the frequency changer circuits using a hybrid ring as a signal distributor, in the miniaturization and the weight reduction of the signal distributor, there is a problem as follows.

The conventional branch line type hybrid ring mentioned above is made of four microstrip lines with a line length of λg/4 (λg is the wavelength) formed on a dielectric board such as ceramic and glass epoxy. For this reason, it is difficult to make a hybrid ring in a reduced size because the wavelength is long in a low frequency band. As a means for miniaturization, a method which uses a high magnetic permeability board is generally well-known, but its limited utility is a problem in the way of miniaturization.

## SUMMARY OF THE INVENTION

It is an object of the present invention, instead of using a conventionally-used hybrid ring, to use a reduced-size signal distributor for outputting signals to a balanced type frequency changer circuit, and to thereby reduce the size and the weight of the radio section.

Another object of the present invention is to reduce the size and the weight of a radio terminal equipment such as automobile telephones.

The above objects can be achieved by winding enamelled wires around a toroidal core, providing each terminal with an adjusting capacitor, and connecting the wires to earth conductors or earth terminals in order to get output signals of equiphase components from one input signal and also get output signals of antiphase components from the other input signal when two different input signals are inputted from the two input terminals.

When a signal is inputted from one input terminal, equiphase components are outputted from the output terminals. When a signal is inputted from the other input terminal, antiphase components are outputted from the output terminals.

By the arrangement mentioned above, a signal distributor can be formed without using microstrip lines. In contrast to the branch line type hybrid ring, this signal distributor has smaller pattern regions on the board, and can be mounted on the board as a small functional device, and can also be reduced in size.

## BRIEF DESCRIPTION OF THE DRAWINGS

Preferred embodiments of the present invention will now be described in conjunction with the accompanying drawings, in which:

Fig. 1 is a circuit diagram showing a conventional branch line type hybrid ring;

Fig. 2 is a perspective view of actual wiring of a main part of the signal distributor according to a first embodiment of the present invention;

Fig. 3 is a plan view showing a circuit wiring of the signal distributor according to a second embodiment of the present invention;

Fig. 4 is a plan view of an as-mounted construction of the signal distributor according to a third embodiment of the present invention;

Fig. 5 is a plan view of an as-mounted construction of the signal distributor according to a fourth embodiment of the present invention; and

Fig. 6 is a circuit diagram according to a fifth embodiment of the present invention, in which the signal distributor and a balanced frequency changer circuit are combined.

## DESCRIPTION OF THE PREFERRED EMBODIMENTS

Fig. 2 is a perspective view of actual wiring of a main part of the signal distributor according to a first embodiment of the present invention.

In Fig. 2, reference numerals 1 and 2 denote input terminals, 3 and 4 denote output terminals, 5 denotes a toroidal core, 6, 6A, 7 and 7B denote insulated wires, and 6-1, 6-2, 6A-1, 6A-2, 7-1, 7-2, 7A-1, 7A-2, 7B-1, and 7B-2 denote ends of the insulated wires. A twisted wire of insulated wires 6 and 6A connected to the common input terminal 1 is separated to the insulated wires 6 and 6A, which are respectively wound at least one turn around the toroidal core 5 in mutually opposite directions, x and y, and one-side ends 6-1 and 6A-1 of the insulated wires are connected to the input terminal 1, while one 6-2 of the other ends of the insulated wires opposite the ends connected to the input terminal 1 is connected to the output terminal 4, and the other 6A-2 of the other ends is connected to the output terminal 3. Three insulated wires 7, 7A and 7B are twisted and wound at least one turn around the toroidal core 5, and a group of the end portions 7-1, 7A-2, 7B-1 and a group of the end portions 7-2, 7A-1 and 7B-2 of the insulated wires are twisted once at outside of the toroidal core 5, and the end 7-1 is connected to the output terminal 3, the end 7B-1 to the input terminal 2, the end 7A-1 to the output terminal 4, and the ends 7A-2, 7-2, and 7B-2 to the earth conductor or the earth terminal.

By the above arrangement, when a signal is inputted from the input terminal 1, signals of equiphase components are outputted at the output terminals 3 and 4, and when a signal is inputted from the input terminal 2, signals of antiphase components are outputted at the output terminals 3 and 4. Thus, a signal distributor can be formed without using microstrip lines, so that it is possible to produce a signal distributor with reduced size and weight.

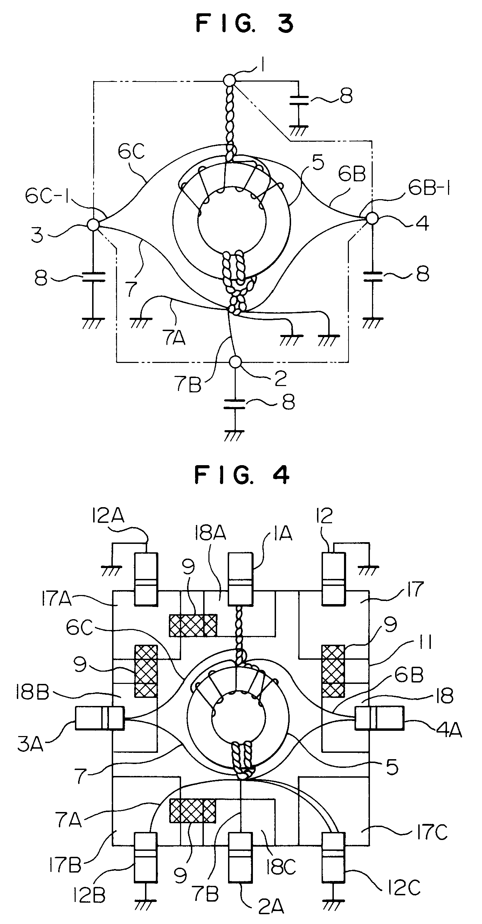

Fig. 3 is a plan view of a circuit wiring of the signal distributor according to a second embodiment of the present invention.

In Fig. 3, the twisted wire of insulated wires 6B and 6C connected to the common input terminal 1 is separated, and the separated are insulated wires 6B and 6C are respectively wound at least one turn around the toroidal core 5 in mutually opposite directions, then, the end portions 6B-1 and 6C-1 are turned around the twisted wire of 6B and 6C connected to the input terminal 1, and the end 6B-1 is connected to the output terminal 4, while the end 6C-1 is connected to the output terminal 3. The wirings other than this are the same as in Fig. 2. By connecting adjusting capacitors 8 respectively between the input terminals 1 and 2 and the output terminals 3 and 4, and the earth conductors or earth terminals, the input/output standing wave ratio can be improved and therefore, its loss factor can be reduced. Also in the second embodiment, the signal distributor can be reduced in size and weight.

Fig. 4 is a plan view of an as-mounted construction of the signal distributor according to a third embodiment of the present invention.

In Fig. 4, for a base 11, a material such as ceramic, plastic, or glass epoxy, which permits pattern printing and etching, patterns 17, 17A, 17B, 17C, 18, 18A, 18B, and 18C are formed, adjusting capacitors 9 are mounted on the base 11 between input pins 1A and 2A and output pins 3A and 4A, and earthing pins 12, 12A, 12B, and 12C, and a toroidal core 5 and circuit wiring shown in Fig. 2 are provided. The pins and the patterns are in the conducting state where they are in contact with each other. By providing the toroidal core 5, circuit wiring and adjusting capacitors 9 on the same board, those components can be handled as a discrete part, and by using pins provided, this discrete part can be mounted on a circuit board. In the third embodiment, the signal distributor can be reduced in size and weight.

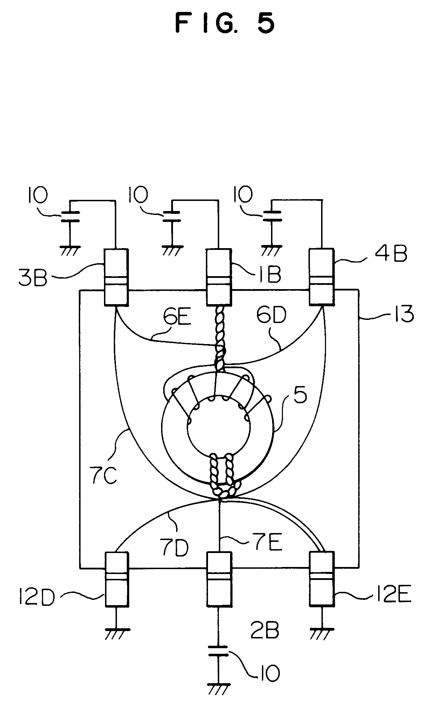

Fig. 5 is a plan view of an as-mounted construction of the signal distributor according to a fourth embodiment of the present invention.

In Fig. 5, a toroidal core 5 and circuit wiring are mounted on a base 13, and adjusting capacitors 10 are connected on the base side to input pins 1B and 2B and output pins 3B and 4B and on the other side to earth conductors or earth terminals. As for the size of the base 13, since the adjusting capacitors 10 are provided outside the base, the base 13 in the fourth embodiment may be made smaller in size than that in Fig. 4. In the fourth embodiment, the same effects as in the third embodiment can be obtained.

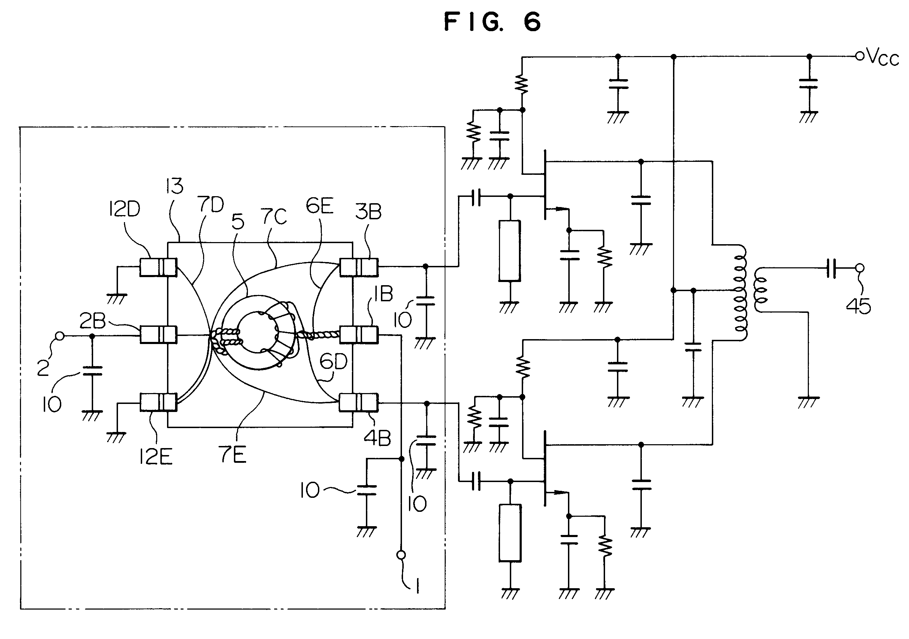

Fig. 6 is a circuit diagram according to a fifth embodiment of the present invention, in which the signal distributor and a balanced frequency changer circuit are combined.

In Fig. 6, signals are inputted to the respective input terminals of the signal distributor and signals are outputted at the output terminals of the signal distributor. At a stage subsequent to the output terminals, there are provided nonlinear elements such as bipolar transistors, FETs or diodes by which the two signals are mixed, and a difference or a sum of frequencies of input signals is outputted. Or, a received signal and an originating signal are inputted and mixed, and a difference of frequencies of the two input signals, that is, an intermediate frequency signal is outputted. Then, an originating signal and an intermediate frequency signal are inputted and mixed, and a difference of the two input signals, that is, a transmitting signal is outputted.

To take the AMPS (Advanced Mobile Phone Service) system in the U.S. as an example, in Fig. 6, by applying an originating signal to the input terminal 2 (914 MHz to 939 MHz) and an input signal (869 MHz to 894 MHz) to the input terminal 1, an intermediate frequency signal (45 MHz) can be obtained which is outputted at an output terminal 45. In addition, by applying an originating signal (914 MHz to 939 MHz) to the input terminal 2 and an intermediate frequency signal (90 MHz) to the input terminal 1, a transmitter signal (824 MHz to 849 MHz) can be obtained which is outputted to the output terminal 45.

Thus, in the sixth embodiment, a signal distributor can be formed without using microstrip lines, so that the signal distributor can be made in a small size. Further, if the frequency changer circuit is made in MMIC (Micro Wave Monolithic Integrated Circuit) and the circuit is combined with the above-mentioned signal distributor, the frequency changer circuit can be made in a much smaller configuration. So, this circuit can be mounted as a functional part when making a small-size lightweight communication equipment such as an automobile telephone.

As has been described in detail, according to the present invention, the signal distributor for outputting signals to a balanced frequency changer circuit can be made in a small size, so that the radio component can be reduced in size and weight. In addition, the size and weight of the radio terminal unit of an automobile telephone can be reduced, thereby increasing the added value.

## Claims

1. In a signal distributor circuit comprising a core (5) having insulated wires (6, 6A, 6B, 6C, 6D, 6E, 7, 7A, 7B, 7C, 7D, 7E) wound therearound, a signal distributor having two input terminals (1, 2), and two output terminals (3, 4), characterized in that said insulated wires such as enamelled wires are wound at least one turn around said toroidal core (5), said input terminals (1 and 2) are connected to said output terminals (3, 4) and also to earth terminals or earth conductors, while said output terminals (3, 4) are connected to earth terminals or earth conductors, from an input signal from one input terminal (1 or 2), signals of equiphase components are outputted at the output terminals (3, 4), and from an input signal from the other input terminal (1 or 2), signals of antiphase components are outputted at the output terminals (3, 4).

2. A signal distributor according to claim 1, characterized in that adjusting capacitors (8, 9, 10) are on one side connected to said terminals (1, 2, 3, 4), and on the other side connected to earth conductors or earth terminals.

3. A signal distributor according to claim 1, characterized in that two insulated wires on one side connected to one common input terminal (1 or 2) are on the other side wound several turns around the toroidal core (5) in mutually opposite directions and then respectively connected to the output terminals (3, 4), on the other hand, one insulated wire connected to the other input terminal (1 or 2) and insulated wires connected to the output terminals (3, 4) are twisted together and wound several turns in the same direction around the toroidal core (5), and the portions of the three insulated wires not connected to the input terminal (1 or 2) and the output terminals (3, 4) are respectively connected to earth conductors or terminals.

4. A signal distributor according to claim 1, characterized in that the range of frequencies at which the signal distributor is operated is from 0.05 GHz to 3 GHz.

5. A signal distributor according to claim 1, characterized in that said toroidal core (5) having the insulated wires wound therearound and adjusting capacitors (9) are mounted on the same base (11) to form a single package, and that an insulating material such as a plastic resin or ceramic is used for the base (11).

6. A signal distributor according to claim 1, characterized in that the toroidal core (5) having the insulated wires wound therearound is mounted on the base (13) to form a single package, that adjusting capacitors are mounted outside, and an insulating material such as a plastic resin or ceramic is used for the base (13).

7. A signal distributor according to claim 1, characterized in that signals are inputted to the respective input terminals of the signal distributor and signals are outputted at the output terminals of the signal distributor, the two signals are mixed by nonlinear elements such as bipolar transistors, FETS or diodes provided at a stage subsequent to the output terminals, and a difference or a sum of frequencies of input signals is outputted, and then, an originating signal and an intermediate frequency signal are inputted and mixed, and a difference of the two input signals, that is, a transmitter signal is outputted.

8. A signal distributor according to claim 1, characterized in that a communication equipment is provided which incorporates a printed circuit board having a combination of a signal distributor and a frequency changer circuit.

# FIG. 1 PRIOR ART

# FIG. 2

# F I G. 3

# F I G. 4

EP 0 506 099 A2

# F I G. 5

8

# FIG. 6

EP 0 506 099 A2